# EUROPEAN PATENT APPLICATION

(11) **EP 4 459 002 A1**
(43) Date of publication of application: **06.11.2024**
(21) Application number: 22915797.9
(22) Date of filing: 19.12.2022
(51) Int. Cl.: C23C 4/02, H01L 21/683

(54) **MASKING JIG**

(30) Priority: 29.12.2021 JP 2021005010 U
(71) Applicant: NHK Spring Co., Ltd., Yokohama-shi, Kanagawa 236-0004 (JP)
(72) Inventor: KANEDA, Noriyoshi, Yokohama-shi, Kanagawa 236-0004 (JP); YOKOYAMA, Hibiki, Yokohama-shi, Kanagawa 236-0004 (JP); FUJII, Masahiro, Yokohama-shi, Kanagawa 236-0004 (JP)
(74) Representative: dompatent von Kreisler Selting Werner - Partnerschaft von Patent- und Rechtsanwälten mbB
(86) International application number: PCT/JP2022/046646
(87) International publication number: WO 2023/127573

(57) **Abstract**

A masking fixture according to an embodiment of the present disclosure includes an insertion portion fitted into an opening of a workpiece, a covering portion above the insertion portion covering the opening of the workpiece, and an eave portion above the covering portion projecting outwards from an outer edge of the covering portion. In the masking fixture, the eave portion may be arranged higher than the top surface of the workpiece when the insertion portion is fitted into the opening of the workpiece, and a protruding portion may be arranged at the top of the eave portion. The masking fixture may be made of resin.

## Description

### TECHNICAL FIELD

The present disclosure relates to a structure of a masking fixture that can be used when spraying a workpiece.

### BACKGROUND ART

A technology is disclosed for spraying a ceramic insulating film onto a metal workpiece (also called "base material" or "component") in order to provide a high voltage and heat resistance (for example, Patent Literature 1).

### CITATION LIST

### PATENT LITERATURE

Patent Literature 1: Japanese Unexamined Patent Application Publication No. 2014-013874

### SUMMARY OF INVENTION

### TECHNICAL PROBLEM

The thermal spray process uses a heat source to melt or soften materials such as metals and ceramics and then injects the molten particles onto a workpiece to form a coating film, so it is difficult to separate the areas where the coating film is deposited from those where the coating film is not deposited. Therefore, it is necessary to mask the areas on the workpiece where the coating film is not to be deposited beforehand. For example, when the workpiece has openings, the openings need to be masked to prevent them from being filled with the coating film. However, using masking tape is time-consuming and it is difficult to precisely adjust the extent of the masking.

In view of these problems, it is an object of the present disclosure to provide a fixture that enables easy masking when forming a coating film on the surface of a workpiece by thermal spraying.

### SOLUTION TO PROBLEM

A masking fixture according to an embodiment of the present disclosure includes an insertion portion fitted into an opening of a workpiece, a covering portion above the insertion portion covering the opening of the workpiece, and an eave portion above the covering portion projecting outwards from an outer edge of the covering portion.

In an embodiment of the present disclosure, the eave portion is preferably located higher than a top surface of the workpiece when the insertion portion is fitted into the opening of the workpiece. The eave portion may include a protruding portion at an upper side. The eave portion may have a cross-sectional taper shape.

In an embodiment of the present disclosure, the masking fixture is preferably made of resin.

### ADVANTAGEOUS EFFECTS OF INVENTION

According to an embodiment of the present disclosure, the masking fixture, which has the eave portion at the upper part and is fixed by inserting it into the opening of the workpiece, simplifies the masking process and improves productivity.

### BRIEF DESCRIPTION OF DRAWINGS

FIG. 1A is a plan view of a masking fixture according to an embodiment of the present disclosure.
FIG. 1B is a cross-sectional view of a masking fixture according to an embodiment of the present disclosure.
FIG. 2A is a plan view of a masking fixture attached to a workpiece according to an embodiment of the present disclosure.
FIG. 2B is a cross-sectional view of a masking fixture attached to a workpiece according to an embodiment of the present disclosure.
FIG. 3A is a plan view of a masking fixture attached to a workpiece according to an embodiment of the present disclosure.
FIG. 3B is a partial cross-sectional view of a workpiece with a masking fixture attached when the masking fixture according to an embodiment of the present disclosure is attached to the workpiece.
FIG. 4 is a partial cross-sectional view of a workpiece attached to a masking fixture according to an embodiment of the present disclosure.

### DESCRIPTION OF EMBODIMENTS

Hereinafter, each embodiment of the present disclosure will be described with reference to drawings and the like. However, the present disclosure may be implemented in various ways to the extent that it does not deviate from the gist thereof and shall not be construed as being limited to the description of the embodiments illustrated below.

The drawings may be represented schematically with respect to the width, thickness, shape, and the like of each portion in comparison with the actual embodiment in order to make the description clearer, but they are examples only and do not limit the interpretation of the present disclosure. In this description and the drawings, elements having functions similar to those described with reference to existing drawings may be denoted by the same reference numerals and duplicate descriptions may be omitted.

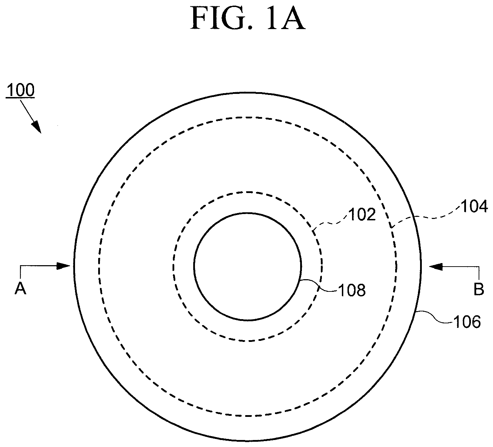

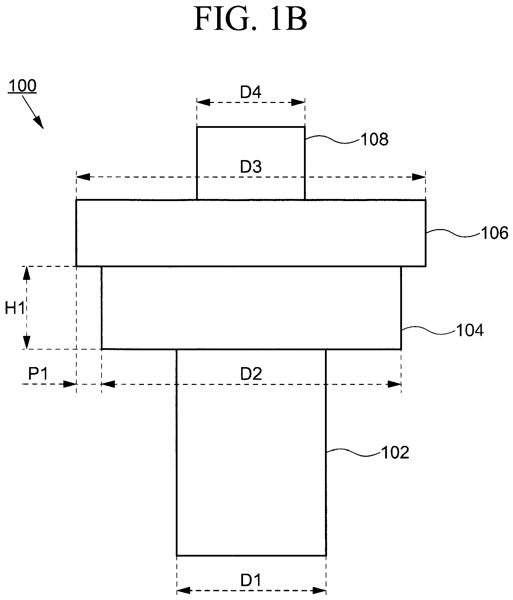

FIG. 1 shows a structure of a masking fixture 100 according to an embodiment of the present disclosure. FIG. 1A shows a plan view of the masking fixture 100 and FIG. 1B shows a cross-sectional view corresponding to A-B shown in the plan view. The masking fixture 100 shown in FIG. 1A and FIG. 1B is a masking fixture that is attached to a portion where a coating film is not formed when the coating film is formed on the surface of the workpiece by a thermal spray process.

The masking fixture 100 is an elongated pin-shaped component having a shape in which a plurality of portions with different external diameters are connected along the longitudinal direction in appearance. The masking fixture 100 having the external shape shown in FIG. 1A and FIG. 1B can be provided as an integrated molding. The masking fixture 100 can be divided into portions named: an insertion portion 102, a covering portion 104 above the insertion portion 102, and an eave portion 106 above the covering portion 104. The masking fixture 100 may further include a protruding portion 108 protruding upwards above the eave portion 106.

Each portion configuring the masking fixture 100 has a different function. The insertion portion 102 is a portion inserted into an opening (not shown) in the workpiece and has the function of fixing the masking fixture 100 to the workpiece. The covering portion 104 is a portion that covers the opening and has the function of preventing any coating film to be formed on the opening. The eave portion 106 has a function of adjusting a range of film deposition so that the coating film is not deposited thickly on a side of the covering portion 104. The protruding portion 108 is disposed for an operator to hold the masking fixture 100 between the fingertips when attaching and removing it from the workpiece.

FIG. 1A and FIG. 1B show that the insertion portion 102, the covering portion 104 and the eave portion 106 configuring the masking fixture 100 are cylindrical, each having a different external diameter. Specifically, an external diameter D2 of the covering portion 104 is larger than an external diameter D1 of the insertion portion 102, and an external diameter D3 of the eave portion 106 is larger than the external diameter D2 of the covering portion 104. An external diameter D4 of the protruding portion 108 is optional and is required to be smaller than the external diameter D3 so as not to impair the function of the eave portion 106.

A molten or softened material sprayed during thermal spraying is ideally sprayed from a direction that is roughly perpendicular to a surface of the masking fixture. When the masking fixture 100 is attached to the workpiece, the area under the eave portion 106 is shaded and acts to inhibit the deposition of the molten or softened material being sprayed, but the coating film is formed to some extent even in the shaded area of the eave portion 106 due to the presence of a come around.

A thickness of the coating film formed under the eave portion 106 by the thermal spraying process can be adjusted by a length P1 of the protruding eave portion 106 and a height H1 of the covering portion 104. The length P1 of the eave portion 106 protruding from the covering portion 104 has the relationship P1 = 1/2 (D3 - D2). As the external diameter D3 of the eave portion 106 has the relationship D3 > D2 compared to the external diameter D2 of the covering portion 104, the length P1 to which the eave portion 106 protrudes can be freely adjusted by the external diameter D3 of the eave portion 106. As is clear from the structure shown in FIG. 1B, the height H1 of the covering portion 104 can also be set independently.

It is possible to change the dimensions and shape of the masking fixture 100 to suit various shapes of workpieces. FIG. 1A and FIG. 1B show the shape of the masking fixture 100 having a cylindrical outline and being used for masking circular openings formed in the workpiece. However, when the openings formed in the workpiece are square, the masking fixture may have a prism-shaped outline.

The masking fixture 100 may be applied to various thermal spray materials. Metals, alloys, cermet, and ceramics are examples of thermal spray materials. In the thermal spray process, the thermal spray material is sprayed onto the workpiece, including the area to which the masking fixture 100 is attached. The coating film formed on the surface of the workpiece by the thermal spray process is preferably firmly adhered, but it is preferable that the thermal spray material does not adhere to the surface of the masking fixture 100 (it is difficult to adhere) or can be easily removed even if it does adhere to the surface of the masking fixture 100.

In order to meet these requirements, the masking fixture 100 is preferably made of a resin material or at least the surface is coated with a resin material. The resin material is preferably a fluoropolymer, for example PTFE (polytetrafluoroethylene), due to its heat resistance and the ease of removing the coating film formed by the thermal spraying process.

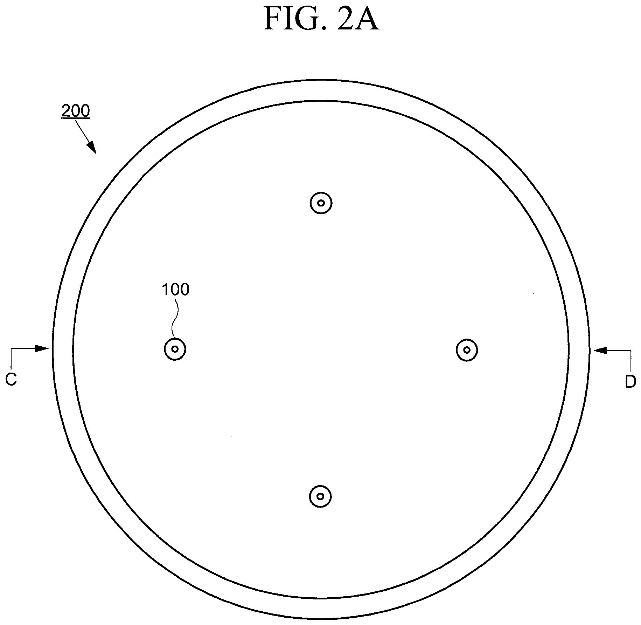

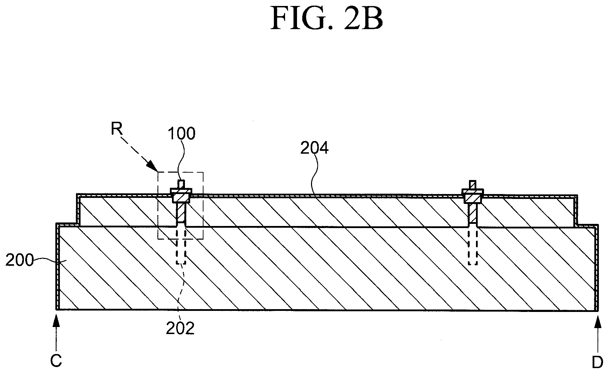

FIG. 2 shows the masking fixture 100 attached to a workpiece 200. FIG. 2A shows a plan view of the workpiece 200 and FIG. 2B shows a cross-sectional structure corresponding to C-D shown in the plan view. FIG. 2A and FIG. 2B show a case where the workpiece 200 is a substrate stage supporting a semiconductor substrate or a glass substrate in a semiconductor manufacturing apparatus. The workpiece 200 is not limited to the shape shown in the figures, and there is no particular limitation in shape as long as the masking fixture 100 is attached to the area where the coating film is formed by the thermal spraying process.

As shown in FIG. 2A, at least one masking fixture 100 is attached to the surface of the workpiece 200 on which the coating film is formed by the thermal spraying process. FIG. 2A shows an example where the masking fixture 100 is attached to four points on the workpiece 200. FIG. 2B shows that the workpiece 200 has openings 202. The openings 202 have a predetermined depth from the surface of the workpiece 200. The masking fixture 100 is inserted into each of the openings 202. Although a coating film 204 is formed on an upper surface and a side surface of the workpiece 200 by the thermal spraying process, the coating film is not formed on the openings 202 due to the masking fixture 100.

A thickness of the coating film 204 formed by the thermal spraying process is around 100 µm to 1,500 µm. The masking fixture 100, which is attached to the surface of the workpiece 200, preferably protrudes upwards sufficiently higher than the thickness of the coating film 204, as it becomes difficult to remove the fixture if it is embedded by the coating film 204. For example, the masking fixture 100 preferably protrudes at least 1 mm above the surface of the workpiece 200.

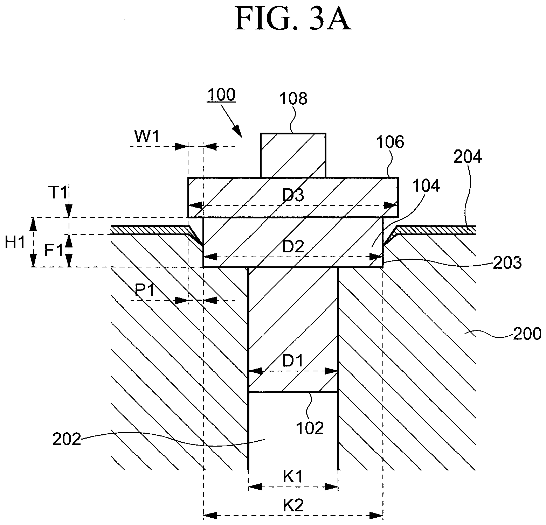

Next, details of the openings 202 in the workpiece 200 and the state of attachment of the masking fixture 100 are explained with reference to FIG. 3A. FIG. 3A shows an enlarged view of the region R shown in FIG. 2B.

FIG. 3A is a cross-sectional view of the masking fixture 100 attached to the workpiece 200. FIG. 3A shows a shape in which an opening groove 203 having a predetermined depth F1 from the upper surface of the workpiece 200 and a diameter K2 wider than a diameter K1 is formed in the upper part of the opening 202 having the diameter K1. In other words, FIG. 3A shows a shape in which a counterbore having a depth F1 and a diameter K2 is formed at the top of the opening 202 having the diameter K1. Furthermore, an upper edge of the aperture groove 203 is preferably counter-bored (shaved) in a tapered shape over a width W1.

As described with reference to FIG. 1B, the masking fixture 100 has the insertion portion 102 having the external diameter D1, the covering portion 104 having the external diameter D2 and the eave portion 106 having the external diameter D3. The external diameter D1 of the insertion portion 102 and the diameter K1 of the opening 202 are approximately the same diameter, while the external diameter D2 of the covering portion 104 and the diameter K2 of the opening groove 203 are approximately the same diameter. The masking fixture 100 can be attached to the workpiece 200 in such a way that the insertion portion 102 is inserted into the opening 202 and the covering portion 104 is fitted into the opening groove 203, so that it cannot easily fall out during the thermal spraying process. The masking fixture 100 can then cover (plug) the opening 202 by the masking fixture 100, as the covering portion 104 has an external diameter that is approximately the same as the opening groove 203.

As the height H1 of the covering portion 104 is greater than the depth F1 of the opening groove 203, the eave portion 106 is located higher than the top surface of the workpiece 200 when the masking fixture 100 is attached to the workpiece 200. That is, when the masking fixture 100 is attached to the workpiece 200, the eave portion 106 is arranged to float upwards from the surface of the workpiece 200, rather than in contact with the workpiece 200. FIG. 3A shows a situation where a bottom edge of the eave portion 106 is located at a height T1 higher than the top surface of the workpiece 200, due to the height H1 of the covering portion 104 being greater than the depth F1 of the opening groove 203.

As described with reference to FIG. 1B, the eave portion 106 is shaped to protrude from the covering portion 104 by the length P1. The length P1 of the protruding eave portion 106 may be roughly the same as the width W1 of the tapered portion at the upper end of the opening groove 203. When the molten or softened material is sprayed onto the surface of the workpiece 200 by the thermal spraying process, the coating film 204 is deposited with an approximate constant thickness on the flat portions that are not shaded by the eave portions 106. In the area shaded by the eave portion 106, that is, the tapered portion, the coating film is not deposited at all, but the coating film 204 is deposited as the molten or softened material comes around the eave portion 106. The coating film 204 deposited on the tapered portion gradually becomes thinner from the area overlapping the outer edge of the eave portion 106 to the inner region. This change in thickness of the coating film 204 is due to a decrease in the amount of molten or softened material going around the eave portion 106 towards the inner side of the eave portion 106. Based on this phenomenon, it is possible to adjust the amount of molten or softened material that comes around by the height H1 of the covering portion 104 of the masking fixture 100 and the protruding length P1 of the eave portion 106, in addition to the conditions of the thermal spraying process.

If the masking fixture does not have the eave portion 106, a thick portion of the coating film 204 will adhere to the side of the covering portion 104. In this case, when the masking fixture is popped off the workpiece 200, the coating film 204 may be stressed and cracks or peeling may occur. In contrast, it is possible to gradually reduce the thickness of the coating film 204 by using the masking fixture 100 having the eave portion 106, so that stress is not exerted as much as possible when the masking fixture 100 is pulled out from the workpiece 200. Further, when stress acts on the coating film 204 when the masking fixture 100 is pulled out, by providing a tapered portion on the upper portion of the opening groove 203, it is possible to disperse the stress due to the bending shape of the coating film 204, and it is possible to suppress the generation of cracks and peeling.

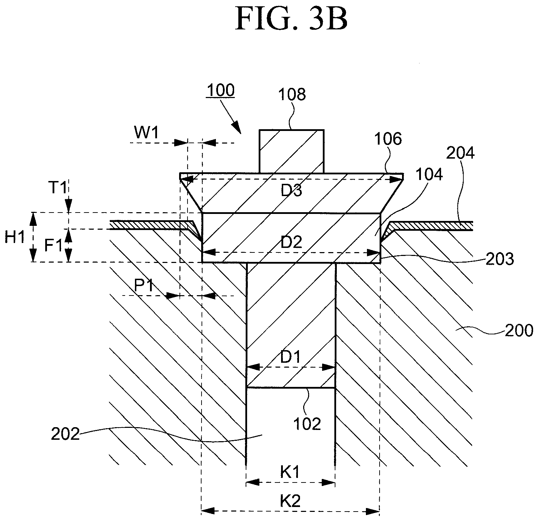

FIG. 3B shows a tapered shape (reverse tapered shape) in which an upper end portion protrudes outward from a lower end portion in the cross-sectional shape of the eave portion 106. As illustrated in FIG. 3B, the length P1 of the protruding eave portion 106 may be greater than the width W1 of the tapered portion of the opening groove 203. Since the eave portion 106 has a tapered shape, the amount of molten or softened material that can come around can be increased and the thickness of the coating film 204 deposited on the tapered portion of the opening groove 203 can be increased. It is possible to control the thickness of the coating film 204 by the shape of the eave portion 106, as the amount of molten or softened material come around can be adjusted by the taper angle of the taper of the eave portion 106 (that is, the amount of come around can be increased when the taper rises close to vertical, and vice versa, and the amount of come around can be reduced).

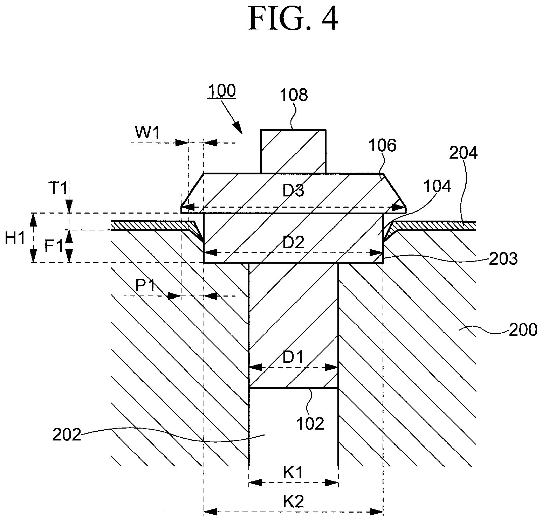

FIG. 4 shows an example in which the cross-sectional shape of the end portion of the eave portion 106 is opposite to that of FIG. 3B, and the end portion of the eave portion 106 has a tapered shape (forward tapered shape) such that the lower end portion protrudes outward from the upper end portion. Even when the cross-sectional shape at the edge of the eave portion 106 has a forward taper shape, the amount of molten or softened material that comes around can be controlled, and the thickness of the coating film 204 deposited on the tapered portion of the opening groove 203 can be controlled. It is possible to prevent the deposition of the coating film on the sides of the eave portion 106 by having such a forward tapered shape of the edge of the eave portion 106, and even if there is deposition on the sides, the amount of the deposition can be reduced.

As described above, according to the masking fixture 100 of the present disclosure, the film deposition range and the thickness of the coating film 204 formed by the thermal spraying process on the surface of the workpiece 200 can be adjusted. The film deposition range of the coating film 204 can be adjusted by the external shape of the masking fixture 100, so that it can flexibly respond to changes in the size and shape of the openings 202 formed in the workpiece 200. Furthermore, the masking fixture 100 can be easily attached and detached by simply inserting it into the opening 202 of the workpiece 200 and pulling it out again, thereby improving productivity. The masking fixture 100 is made of resin to prevent the build-up of thermally sprayed coating, and even if it does build-up, the coating can be easily removed so that it can be reused.

### REFERENCES SIGNS LIST

100: masking fixture,
102: insertion portion,
104: covering portion,
106: eave portion,
108: protruding portion,
200: workpiece,
202: opening,
203: opening groove,
204: coating film

## Claims

1. A masking fixture, comprising:
an insertion portion fitted into an opening in a workpiece;
a covering portion above the insertion portion and covering the opening of the workpiece; and
an eave portion above the covering portion and projecting outwards from an outer end of the covering portion.

2. The masking fixture according to claim 1, wherein the eave portion is located higher than a top surface of the workpiece when the insertion portion is fitted into the opening of the workpiece.

3. The masking fixture according to claim 1, wherein the eave portion includes a protruding portion at an upper side.

4. The masking fixture according to claim 1, wherein a cross-sectional shape of the eave portion has a tapered shape.

5. The masking fixture according to any one of claims 1 to 4, wherein the insertion portion, the covering portion and the eave portion are made of resin.
